# FASCICULE DE BREVET EUROPEEN

(11) **EP 4 168 279 B1**
(45) Date de publication et mention de la délivrance du brevet: **07.08.2024**
(21) Numéro de dépôt: 21742722.8
(22) Date de dépôt: 10.06.2021
(51) Int. Cl.: B60R 25/20, E05F 15/73, H03K 17/955, B60Q 1/30, B60Q 1/22

(54) **DISPOSITIF D'OUVERTURE/FERMETURE D'OUVRANT PAR DÉTECTION DE MOUVEMENT D'UN MEMBRE D'UTILISATEUR ET PROCÉDÉ D'OUVERTURE/FERMETURE ASSOCIÉ**
VORRICHTUNG ZUM ÖFFNEN/SCHLIESSEN EINES ÖFFNUNGSELEMENTS DURCH ERFASSUNG DER BEWEGUNG EINES GLIEDMASSES EINES BENUTZERS UND ZUGEHÖRIGES ÖFFNUNGS-/SCHLIESSVERFAHREN
DEVICE FOR OPENING/CLOSING AN OPENING ELEMENT BY DETECTING MOVEMENT OF A USER'S LIMB, AND ASSOCIATED OPENING/CLOSING METHOD

(30) Priorité: 23.06.2020 FR 2006553
(43) Date de publication de la demande: 26.04.2023
(73) Titulaire: Vitesco Technologies GmbH, 93055 Regensburg (DE)
(72) Inventeur: WROBLEWSKI, Jérome, 31100 Toulouse (FR); PARET, Corinne, 31100 Toulouse (FR); HOURNE, Xavier, 31100 Toulouse (FR)
(74) Mandataire: Vitesco Technologies
(86) Numéro de dépôt international: PCT/EP2021/065656
(87) Numéro de publication internationale: WO 2021/259661

(56) Documents cités:
- EP-A1- 2 947 773
- WO-A1-2012/095157
- WO-A1-2015/110239
- WO-A2-2014/199235
- DE-A1- 102014 015 899
- FR-A3- 2 990 905
- US-A1- 2017 241 186
- US-A1- 2017 241 187
- US-A1- 2018 163 440
- US-A1- 2019 267 993

## Description

### [Domaine technique]

L'invention se rapporte à un dispositif d'ouverture/fermeture d'ouvrant par détection de mouvement d'un membre d'utilisateur, et à un procédé d'ouverture/fermeture associé permettant un accès main libre sécurisé.

### [Etat de la technique antérieure]

L'application principale mais non exclusive de cette invention concerne l'ouverture de coffres de véhicule, pour permettre à l'utilisateur habilité d'ouvrir un coffre avec uniquement un mouvement d'un membre de l'utilisateur, l'utilisateur étant identifié par un badge ou une clé qu'il porte à l'aide d'un module de contrôle BCM (initiales de « body control module » en terminologie anglaise) situé dans le véhicule.

Jusqu'à présent, les demandes d'accès main libre comportent principalement le besoin de positionner une main pour confirmer une demande d'ouverture/fermeture d'ouvrant d'un véhicule (par exemple une portière), et ce processus comporte deux étapes principales : reconnaissance d'une clé ou d'un badge habilité à ouvrir ou fermer le véhicule à proximité de l'ouvrant par le BCM du système d'accès et, dans le cas d'une demande d'ouverture, détection de présence de la main sur une poignée.

La mise en oeuvre de ce procédé nécessite des antennes pour la détection de clés ou des badges habilités, des capteurs de présence dans les poignées, en général des capteurs capacitifs, pour la détection de main, ainsi qu'un système centralisé de gestion des demandes d'accès main libre, qui peut être par exemple un calculateur entièrement ou partiellement dédié à cette fonction.

Concernant l'utilisation du pied pour une ouverture sans contact, une application connue concerne l'ouverture de porte d'une salle d'opération pour le personnel hospitalier. Le modèle d'utilité CN 202 143 044 propose par exemple d'équiper la porte d'un capteur à induction de détection de pied. Les personnes qui souhaitent entrer ou sortir de la salle étendent leur pied près du capteur et le signal détecté par le capteur est transmis à un dispositif de commande d'un mécanisme d'ouverture / fermeture de la porte.

Une utilisation du pied pour un accès main libre au coffre d'une voiture est présentée dans la demande internationale WO 2012/052210. Ce document propose une détection de mouvement typique, par exemple un aller-retour d'une partie du corps de l'utilisateur, par exemple le pied, par un ensemble de détection capacitive à deux électrodes allongées. Ces électrodes s'étendent horizontalement sous le coffre, la plus longue sous la plus courte, et sont couplés à un dispositif de commande et d'évaluation. Les variations de capacité sont suivies par rapport à un potentiel de référence, et lorsque le mouvement typique est dans l'intervalle de détection, une activation est déclenchée, par exemple l'ouverture du coffre. US2019267993A1 divulgue un dispositif de détection capacitif.

Le mouvement typique est un mouvement du type aller-retour de la partie inférieure de la jambe de l'utilisateur. Pour réaliser ce mouvement typique, l'utilisateur doit donc lever sa jambe pour passer son pied ou son tibia en face des électrodes. Ce mouvement n'est donc pas sans risque, surtout quand l'utilisateur porte des objets, est âgé, ou porte des talons. Lever la jambe peut causer un déséquilibre qui peut être exacerbé par la présence d'un sol glissant, gelé par exemple.

De plus, certains véhicules du type « pick up » en anglais, c'est-à-dire des véhicules utilitaires légers en français comprenant une benne ou d'un espace ouvert à l'arrière ou des véhicules du type « SUV », c'est à dire « Sport Utility Vehicles », en anglais ou véhicule utilitaire sport, possédant des capacités tout terrain, sont plus hauts que les véhicules particuliers et leur parechoc est situé plus haut par rapport au sol, ce qui rend la réalisation du mouvement typique hasardeux, voire dangereux.

Il est donc nécessaire de concevoir un dispositif d'ouverture/fermeture d'ouvrant par détection de mouvement d'un membre d'utilisateur, et un procédé d'ouverture/fermeture associé permettant un accès main libre sécurisé qui ne soit pas dangereux pour l'utilisateur et qui soit compatible avec tout type de véhicules.

### [Exposé de l'invention]

L'invention concerne un dispositif d'ouverture/fermeture d'ouvrant de véhicule automobile par détection de mouvement d'un membre d'un utilisateur, ledit dispositif comprenant un capteur de détection d'approche et ou de contact comprenant une électrode unique et des moyens d'analyse des dites variations de capacité de l'électrode, ainsi qu'une unité de contrôle d'ouverture/fermeture d'ouvrant, ledit dispositif étant remarquable en ce qu'il comprend également :
a. un boitier étanche comprenant au moins une première surface en métal ,et au moins une deuxième surface en métal,
b. des moyens de détection d'une forme prédéterminée des dites variations de l'électrode, présentant une comprenant succession d'un nombre prédéterminée de pics d'amplitudes prédéterminées pendant une durée prédéterminée ,
l'au moins première surface et l'au moins deuxième surface étant disjointes, et ladite électrode étant située à l'extérieur du boitier étanche, de telle manière que ladite électrode soit couplée électriquement avec l'au moins première surface et avec l'au moins deuxième surface afin de créer au moins deux zones de détection d'approche et/ou de contact.

Préférentiellement, le boitier étanche comprend un réflecteur et des lampes, et la première surface en métal se présente sous la forme de parties du réflecteur.

Avantageusement, le boitier étanche comprend une partie décorative et la deuxième surface se présente sous la forme de la partie décorative.

La partie décorative peut être située au moins en partie autour du réflecteur.

Dans un mode de réalisation préférentiel, le mouvement prédéterminé est un mouvement d'aller-retour devant le dispositif et le nombre prédéterminé de pics est égal à quatre.

L'invention s'applique également à un phare de véhicule automobile et à un véhicule automobile comprenant le dispositif selon l'une quelconque des caractéristiques énumérées précédemment.

L'invention concerne également un procédé d'ouverture/fermeture d'ouvrant de véhicule automobile par détection de mouvement d'un membre d'un utilisateur par un dispositif d'ouverture/fermeture comprenant un capteur de détection d'approche et ou de contact comprenant une électrode unique, et des moyens d'analyse des dites variations de capacité de l'électrode, ainsi qu'une unité de contrôle d'ouverture/fermeture d'ouvrant, ledit procédé étant remarquable en ce que l'on équipe au préalable le dispositif :
a. d'un boitier étanche comprenant au moins une première surface en métal, et au moins une deuxième surface en métal,
b. de moyens de détection d'une forme prédéterminée des dites variations de l'électrode, présentant une succession d'un nombre prédéterminée de pics d'amplitudes prédéterminées pendant une durée prédéterminée ,
l'au moins première surface et l'au moins deuxième surface étant disjointes, ladite électrode étant située à l'extérieur du boitier, de telle manière que la dite électrode soit couplée électriquement avec l'au moins première surface et avec l'au moins deuxième surface afin de créer au moins deux zones de détection d'approche et/ou de contact, et en ce que le dit procédé comprenne les étapes suivantes :
c. détection d'une forme prédéterminée des dites variations de l'électrode, présentant une succession d'un nombre prédéterminée de pics d'amplitudes prédéterminées pendant une durée prédéterminée ,
d. ouverture/fermeture de l'ouvrant selon la détection ainsi réalisée.

Préférentiellement, le mouvement prédéterminé est un mouvement d'aller-retour devant le dispositif (D) et que le nombre prédéterminé de pics est égal à quatre.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig. 1] : la **figure 1** représente schématiquement un véhicule V comprenant un dispositif d'ouverture/fermeture d'ouvrant selon l'invention,
[Fig. 2] : la **figure 2** représente une vue en coupe du côté gauche d'un phare arrière droit 100 de véhicule comprenant le dispositif D d'ouverture/fermeture selon l'invention,
[Fig. 3] : la **figure 3** représente une vue de dessus côté droit d'un phare arrière droit 100 de véhicule comprenant le dispositif D d'ouverture/fermeture selon l'invention,
[Fig. 4] : la **figure 4** représente une vue éclatée des vues des figures 2 et 3,
[Fig. 5a] : la **figure 5a** représente une première vue de face du dispositif D selon l'invention,
[Fig. 5b] : la **figure 5b** représente une deuxième vue de face du dispositif D selon l'invention,
[Fig. 6] : la **figure 6** illustre schématiquement le dispositif D ainsi que les deux zones capacitives de détection,
[Fig.7] : la **figure 7** est un graphe représentant la variation de capacité aux bornes de l'électrode lorsqu'une main d'un utilisateur passe devant le phare arrière.

### [Description des modes de réalisation]

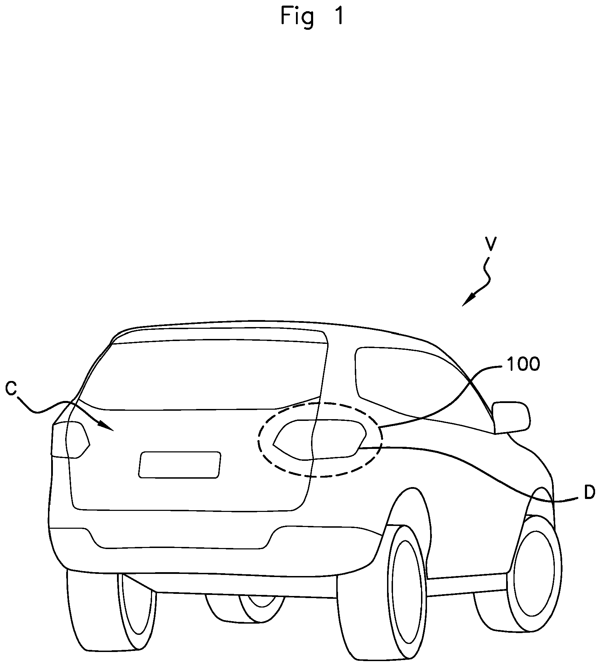

A la figure 1 est représenté un véhicule automobile V comprenant un dispositif d'ouverture/fermeture D d'un ouvrant du véhicule V selon l'invention. Dans l'exemple illustré, il s'agit de l'ouverture/fermeture sans contact physique, c'est-à-dire « mains libres » d'un coffre C du véhicule. Dans cet exemple, le dispositif D est compris dans un phare arrière droit 100 du véhicule V.

Comme mentionné précédemment, l'invention vise à permettre à l'utilisateur d'ouvrir le coffre C de son véhicule sans contact physique et sans les inconvénients (chute par exemple) de l'art antérieur.

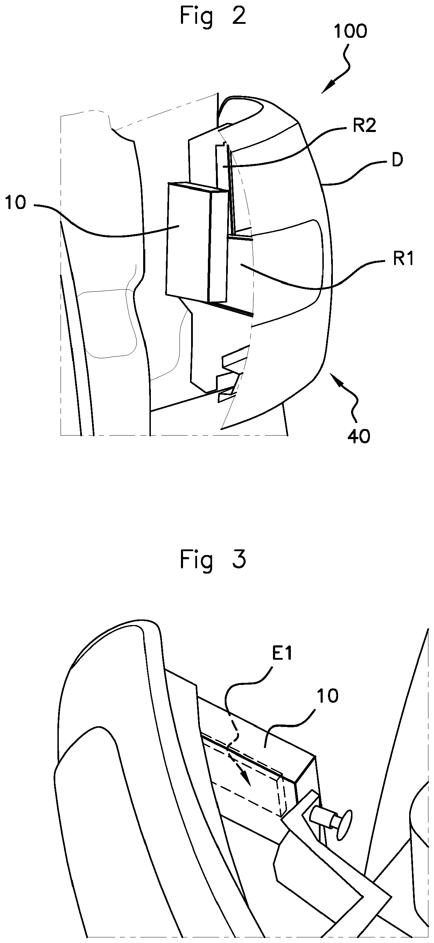

Dans ce but, l'invention propose le dispositif D illustré aux figures 2, 3, 4 et 5a, 5b. A la figure 2, est représentée une vue en coupe du côté gauche du phare arrière droit 100 du véhicule V.

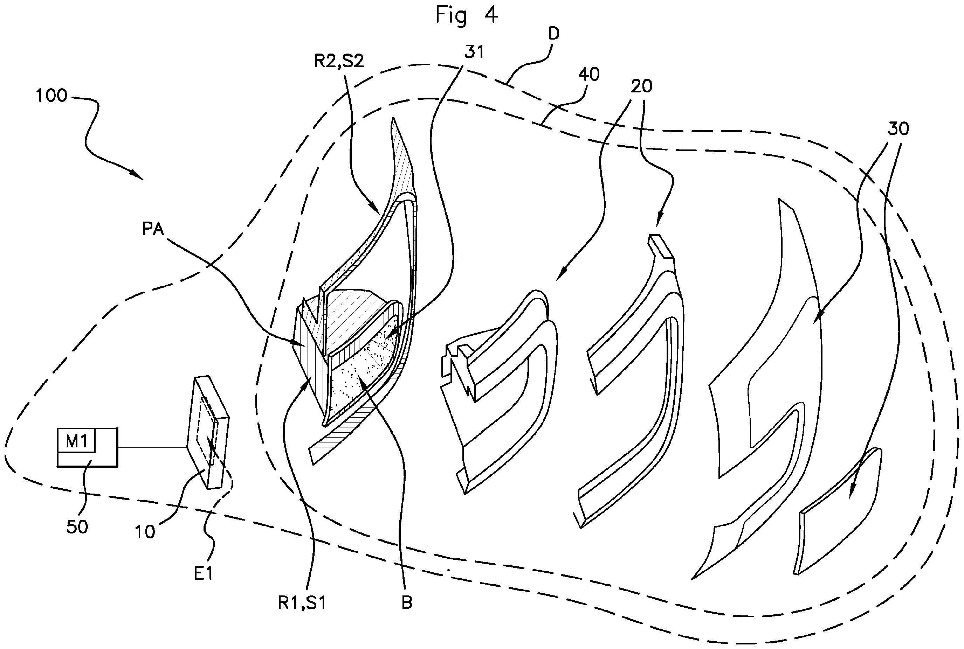

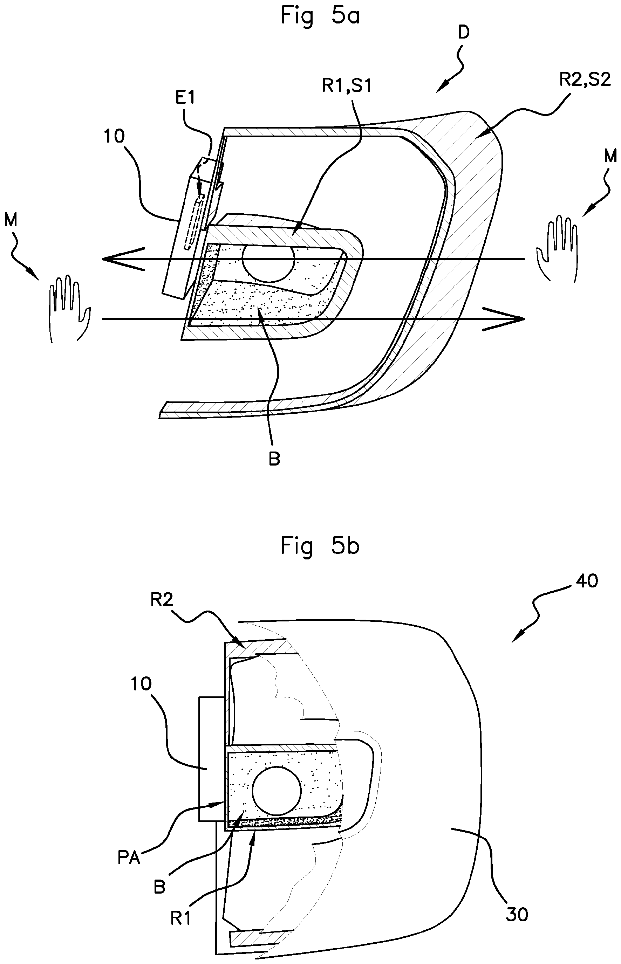

Le phare arrière droit 100 est constitué d'un boitier étanche 40 (cf. Figure 5b) reliés par un faisceau électrique (non représenté) à un module électronique de contrôle et de gestion des phares du véhicule, le boitier étanche 40 est par exemple en matière plastique et comprend de manière non restrictive :
a. un réceptacle B comprenant une ou plusieurs lampes, généralement une ou plusieurs lampes LED (« light emitting diode » en anglais) ou DEL, diodes électroluminescentes, qui doivent être protégées contre l'humidité ainsi qu'un premier réflecteur R1 qui constitue les parois internes du réceptacle,
b. une première vitre 31 qui constitue une paroi du réceptacle,
c. une partie décorative R2 (cf. Figure 4) en métal ou en plastique chromé entourant tout ou en partie le réceptacle B.
d. plusieurs guides de lumière 20 successifs, en plastique emboités les uns aux autres, adaptés, pour concentrer, et/ou diffuser et/ou orienter les faisceaux de lumière provenant des lampes,
e. des vitres transparentes en plastique, colorisées ou pas.

Le réflecteur R1 se présente généralement sous la forme d'un revêtement à fort indice de réfraction de lumière sur les parois internes du réceptacle B. La lumière projetée par le ou les lampes est réfléchie par les parois du réflecteur R1 du réceptacle B puis passe à travers la succession de vitres transparentes (cf. Figure 4), i.e : à travers la première vitre 31 puis à travers les vitres transparentes 30 et les guides de lumières 20 afin de guider la lumière provenant des lampes selon les feux allumés, commandés par le conducteur, qui peuvent correspondre à des feux arrière, des feux clignotants, etc... Le réflecteur R1 est un réflecteur en métal ou en plastique comprenant un revêtement métallique par exemple en plastique chromé.

La partie décorative R2 est visible par l'utilisateur de l'extérieur à travers une des vitres transparentes 30, et constitue un ornement esthétique du phare 100.

Le dispositif D comprend un capteur de proximité 10, comprenant une seule électrode, une électrode unique E1 (cf. figure 4), ainsi que le boitier étanche 40 comprenant au moins deux surfaces métalliques, S1, S2 disjointes, c'est-à-dire non reliés électriquement ou non couplées électriquement entres elles, et une unité électronique de contrôle 50 (représentée à la figure 4).

Le capteur de proximité 10 se présente sous la forme d'un boitier comprenant un capteur capacitif de détection d'approche et/ou de contact, sous la forme de l'électrode E1 reliée à un circuit électronique de mesure de la capacité aux bornes de l'électrode E1. Le capteur 10 est également relié électriquement à l'unité de contrôle 50 elle-même relié au mécanisme (non représenté) d'ouverture/fermeture du coffre C. Le capteur 10 mesure la variation de capacité ΔCe de l'électrode E1, et transmet lesdites variations vers l'unité de contrôle 50 qui comprend des moyens d'analyse desdites variations et envoie ensuite un signal d'ouverture/fermeture au mécanisme du coffre C à partir des variations de capacités ainsi reçues.

Les moyens d'analyse des dites variations de la capacité de l'électrode E1, se présentent sous la forme de moyens de détection M1 d'une forme prédéterminée des dites variations, présentant une succession d'un nombre prédéterminée de pics d'amplitudes prédéterminées dans une durée prédéterminée comme cela est expliquée plus bas.

Dans notre exemple, expliqué plus bas, le nombre prédéterminé de pics est égal à 4, mais cela n'est nullement limitatif.

L'électrode E1 consiste en une surface de métal par exemple de cuivre. Selon l'invention le capteur 10 comprenant l'électrode E1 est situé à l'extérieur du boitier étanche 40, contre ou à proximité d'une paroi externe PA (cf. figure 4) du boitier 40 afin que ladite électrode E1 soit couplée électriquement avec la surface métallique du réflecteur R1, situé à l'intérieur du boitier 40 que l'on appellera première surface métallique S1.

Selon l'invention et de manière ingénieuse, l'électrode E1 est également située en contact ou à proximité de la partie décorative R2, afin d'être couplée électriquement avec ladite partie, que l'on appellera deuxième surface métallique S2. Ceci est illustré à la figure 5.

Ainsi, comme illustré à la figure 5, l'électrode E1 ainsi disposée à l'extérieur du boitier étanche 40 du phare arrière droit 100 est alors couplée électriquement avec la première surface métallique S1, ainsi qu'avec la deuxième surface métallique S2, c'est-à-dire que ladite électrode E1 est couplée électriquement avec les deux surfaces en métal ou en plastique métallisé, ou chromé.

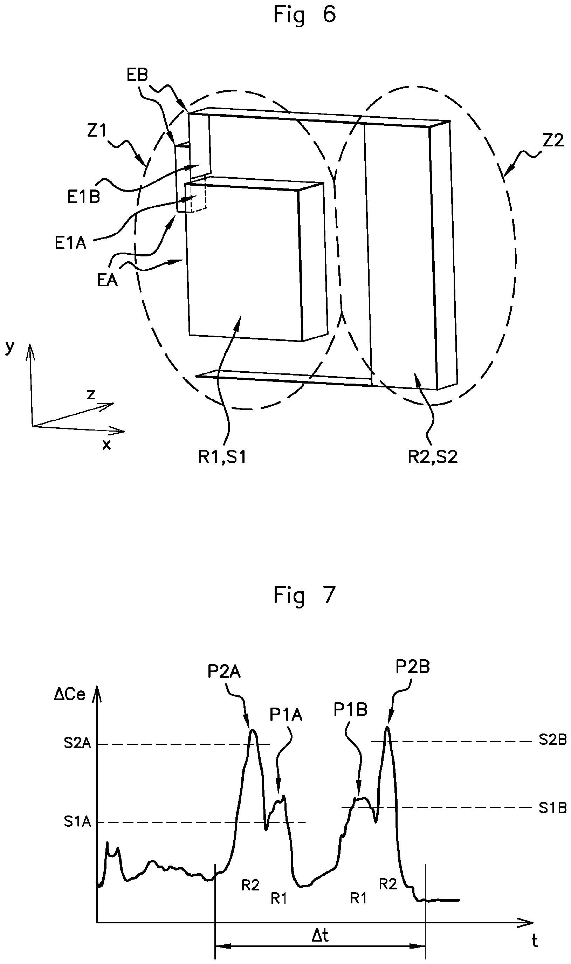

La figure 6 est une vue schématique de la figue 5. La partie E1A de l'électrode E1 qui est coupée électriquement avec la première surface métallique S1 crée une électrode EA définie par les surfaces métalliques constituées de la partie E1A de ladite l'électrode E1 ainsi que de la première surface métallique S1, ce qui génère une première zone Z1 de détection d'approche et/ou de contact autour dudit réflecteur R1.

La partie de l'électrode E1B qui est couplée électriquement avec la deuxième surface métallique S2 crée une électrode EB définie par les surfaces métalliques constituées de la partie E1B de l'électrode E1 ainsi que de la deuxième surface métallique S2, ce qui génère une deuxième zone Z2 de détection d'approche et/ou de contact autour du de la partie décorative R2.

Il est à noter que l'électrode unique E1 peut se présenter sous la forme de deux ou plusieurs parties métalliques reliées électriquement entres elle, une première partie de l'électrode étant couplée électriquement avec la première surface métallique S1 et une deuxième partie de l'électrode étant couplée électriquement avec la deuxième surface métallique S2.

Il est à noter que l'invention ne se limite pas à deux zones de détection, l'électrode E1 peut être ainsi constituée de plusieurs parties d'une seule et même électrode reliées électriquement entres elles, chaque partie étant reliée électriquement à une de plusieurs parties métalliques du phare 100 créant ainsi plusieurs zones de détection.

La géométrie des deux zones de détection Z1, Z2 dépend entre autres de la géométrie des deux surfaces métalliques S1, S2 couplées avec l'électrode E1, c'est-à-dire entre autres de la géométrie des électrodes EA et EB soit, de la géométrie des première et deuxième surfaces métalliques S1, S2.

Le réflecteur R1, et la partie décorative R2 étant de géométries différentes, les premières et deuxième surfaces métalliques sont également de géométrie différente, ce qui a pour conséquence de créer deux zones de détection Z1, Z2 qui sont également de géométries différentes.

On entend par géométrie de zone de détection, les dimensions de ladite zone dans trois axes orthogonaux entre eux, X, Y, Z, illustrés à la figure 6.

Les premières et deuxième surface métalliques S1, S2 étant non couplés électriquement entre eux, par exemple disjoints, les électrodes E1 et EB génèrent chacune une zone de détection soit les deux zones de détection Z1, Z2. Les dites deux zones de détection Z1, Z2 peuvent être disjointes et ne pas se recouper, c'est-à-dire ne pas présenter pas de zone de détection commune, mais elles peuvent également présenter une zone de recoupement, c'est-à-dire une zone de détection commune.

Le procédé d'ouverture/fermeture du coffre C va maintenant être expliqué à la lumière des figures 5a, 6 et 7.

Lorsque l'utilisateur réalise un mouvement prédéterminé, par exemple, d'aller-retour de sa main M devant le dispositif d'ouverture/fermeture D, comme illustré à la figure 5 (flèches allant de gauche à droite et de droite à gauche), ladite main M passe consécutivement dans les zones de détection Z2, Z1 puis Z1, Z2.

La présence de la main est alors détectée consécutivement par les deux électrodes EB, EA puis EA, EB, ce qui fait varier la capacité vue par l'électrode E1.

Cette variation de capacité ΔCe selon le temps t est illustrée à la figure 7. Le mouvement d'aller-retour de la main M de l'utilisateur est caractérisé par une courbe de variation de capacité de l'électrode E1 particulière, c'est-à-dire présentant une forme prédéterminée pendant une durée prédéterminée Δt, et comprenant :
a. deux premiers pics, P2A, P1A, correspondant au premier passage (mouvement aller de droite à gauche de la main M) devant le phare 100, c'est-à-dire passant devant le deuxième R2, c'est dans dire dans la deuxième zone de détection Z2 puis devant le première réflecteur R1, c'est-à-dire dans la première zone de détection Z1,
b. deux deuxièmes pics P1B, P2B correspondants au deuxième passage (mouvement retour de gauche à droite de la main M) devant le premier réflecteur R1, c'est-à-dire dans la première zone de détection Z1, puis devant le deuxième réflecteur R2, c'est-à-dire dans la deuxième zone de détection Z2 .

Les pics de variations P1A, P1B de la capacité de l'électrode E1, correspondent au passage de la main M devant le réflecteur R1. Les pics de variations de la capacité de l'électrode E1, P2A, P2B de la capacité de l'électrode E1 correspondent au passage de la main M devant la partie décorative R2. L'amplitude des pics, P1A, P1B, P2A, P2B dépend de la géométrie des zones de détection Z1, Z2 et donc des dimensions des première et deuxième surfaces métalliques S1, S2.

Dans notre exemple, la forme prédéterminée des variations de l'électrode E1 comprend 4 pics, correspond à deux passages devant chaque des deux éléments, le réflecteur R1, et la partie décorative R2, selon le mouvement prédéterminé de la main M de l'utilisateur.

Bien sûr, l'invention ne se limite à un mouvement d'aller-retour de la main de l'utilisateur M devant le dispositif d'ouverture/fermeture D, mais s'applique également à tout mouvement d'un membre de l'utilisateur devant le dispositif d'ouverture/fermeture D permettant de passer successivement de la première Z1 ou de la deuxième zone de détection Z2 (respectivement) à la deuxième Z2 ou à la première zone de détection Z1, et permettant de créer toute une variation de capacité ΔCe pouvant être comparée à une forme prédéterminée.

L'invention est donc ingénieuse, car il permet l'ouverture du coffre du véhicule en « main libre » sans avoir à lever du sol un membre inférieure. L'invention est d'autant plus remarquable qu'elle permet de s'affranchir de problèmes d'étanchéité dans le boitier du phare en disposant l'électrode en dehors du dit boitier étanche 40 et non à l'intérieur. En effet, disposer l'électrode à l'intérieur du boitier étanche 40 du phare présente le désavantage d'avoir à passer des câbles de l'intérieur du boitier étanche 40 vers l'extérieur, les câbles reliant l'électrode E1 au capteur 10, situé lui à l'extérieur du boitier 40.

Avec la disposition de l'électrode E1 selon l'invention, aucune modification intrusive n'est réalisée dans le boitier 40 qui demeure parfaitement étanche.

De plus l'invention permet de manière judicieuse de créer deux zones de détection en utilisant de manière appropriée les surfaces métalliques disponibles dans le phare. Ainsi une seule électrode permet de générer au moins deux zones de détection, contrairement à l'art antérieur où deux électrodes sont nécessaires pour créer deux zones et rendre la détection robuste.

Le dispositif selon l'invention permet quant à lui une détection robuste et fiable à l'aide d'une seule électrode et sans modification intrusive d'une partie du véhicule qui doit rester étanche.

## Revendications

1. Dispositif (D) d'ouverture/fermeture d'ouvrant de véhicule automobile par détection de mouvement d'un membre d'un utilisateur, ledit dispositif (D) comprenant un capteur de détection d'approche et ou de contact (10) comprenant une électrode unique (E1) et des moyens d'analyse des variations de capacité de l'électrode (E1), ainsi qu'une unité de contrôle d'ouverture/fermeture d'ouvrant (50), ledit dispositif (D) étant **caractérisé en ce qu'**il comprend également :
a) un boitier étanche (40) comprenant au moins une première surface en métal (S1),et au moins une deuxième surface en métal (S2),
b) des moyens de détection (M1) d'une forme prédéterminée des dites variations de l'électrode (E1), présentant une succession d'un nombre prédéterminée de pics (P1A, P2A, P1B, P2B) d'amplitudes prédéterminées (S1A, S2A ,S2B, S1B) pendant une durée prédéterminée (Δt),
l'au moins première surface (S1) et l'au moins deuxième surface (S2) étant disjointes, et ladite électrode (E1) étant située à l'extérieur du boitier étanche (40), de telle manière que ladite électrode (E1) soit couplée électriquement avec l'au moins première surface (S1) et avec l'au moins deuxième surface (S2) afin de créer au moins deux zones de détection (Z1, Z2) d'approche et/ou de contact.

2. Dispositif (D) selon la revendication précédente, **caractérisé en ce que** le boitier étanche (40) comprend un réflecteur (R1) et des lampes, et **en ce que** la première surface en métal (S1) se présente sous la forme de parties du réflecteur (R1).

3. Dispositif (D) selon la revendication 1 ou 2, **caractérisé en ce que** le boitier étanche comprend une partie décorative (R2) et **en ce que** la deuxième surface (S2) se présente sous la forme de la partie décorative (R2).

4. Dispositif (D) selon la revendication précédente, **caractérisé en ce que** la partie décorative (R2) est située au moins en partie autour du réflecteur (R1).

5. Dispositif (D) selon l'une quelconque des revendications précédentes, **caractérisé en ce que** le mouvement est un mouvement d'aller-retour devant le dispositif (D) et que le nombre prédéterminé de pics est égal à quatre.

6. Phare (100) de véhicule automobile (V) comprenant le dispositif (D) selon l'une quelconque des revendications précédentes.

7. Véhicule automobile (V), comprenant un dispositif (D) selon l'une quelconque des revendications 1à 4.

8. Procédé d'ouverture/fermeture d'ouvrant de véhicule automobile par détection de mouvement d'un membre d'un utilisateur par un dispositif d'ouverture/fermeture (D) comprenant un capteur de détection d'approche et ou de contact (10) comprenant une électrode unique (E1), et des moyens d'analyse des variations de capacité de l'électrode (E1), ainsi qu'une unité de contrôle d'ouverture/fermeture d'ouvrant (50), ledit procédé étant **caractérisé en ce que** l'on équipe au préalable ledit dispositif (D) :
a) d'un boitier étanche (40) comprenant au moins une première surface en métal (S1), et au moins une deuxième surface en métal (S2),
b) de moyens de détection d'une forme prédéterminée des dites variations de l'électrode, présentant une succession d'un nombre prédéterminée de pics (P1A, P2A, P1B, P2B) d'amplitudes prédéterminées (S1A, S2A ,S2B, S1B) pendant une durée prédéterminée (Δt),
l'au moins première surface (S1) et l'au moins deuxième surface (S2) étant disjointes, ladite électrode (E1) étant située à l'extérieur du boitier (40), de telle manière que la dite électrode (E1) soit couplée électriquement avec l'au moins première surface (S1) et l'au moins deuxième surface (S2) afin de créer au moins deux zones de détection (Z1, Z2) d'approche et/ou de contact,
et **en ce que** le dit procédé comprenne les étapes suivantes :
c) détection d'une forme prédéterminée des dites variations de l'électrode (E1), présentant une succession d'un nombre prédéterminée de pics (P1A, P2A, P1B, P2B) d'amplitudes prédéterminées (S1A, S2A ,S2B, S1B) pendant une durée prédéterminée (Δt),
d) ouverture/fermeture de l'ouvrant selon la détection ainsi réalisée.

9. Procédé selon la revendication précédente, **caractérisé en ce que** le mouvement est un mouvement d'aller-retour devant le dispositif (D) et que le nombre prédéterminé de pics est égal à quatre.

## Patentansprüche

1. Vorrichtung (D) zum Öffnen/Schließen eines Öffnungselements eines Kraftfahrzeugs durch Erkennung der Bewegung eines Gliedmaßes eines Benutzers, wobei die Vorrichtung (D) einen Sensor zur Erkennung von Annäherung und/oder Kontakt (10) aufweist, der eine einzelne Elektrode (E1) und Mittel zur Analyse der Kapazitätsänderungen der Elektrode (E1) aufweist, sowie eine Steuereinheit zum Öffnen/Schließen des Öffnungselements (50), wobei die Vorrichtung (D) **dadurch gekennzeichnet ist, dass** sie darüber hinaus Folgendes aufweist:
a) ein wasserdichtes Gehäuse (40), das mindestens eine erste Metalloberfläche (S1) und mindestens eine zweite Metalloberfläche (S2) aufweist,
b) Mittel (M1) zur Erkennung einer vorbestimmten Form der genannten Änderungen der Elektrode (E1), die eine Folge einer vorbestimmten Anzahl von Spitzen (P1A, P2A, P1B, P2B) mit vorbestimmten Amplituden (S1A, S2A, S2B, S1B) während einer vorbestimmten Dauer (Δt) aufweisen,
wobei die mindestens erste Oberfläche (S1) und die mindestens zweite Oberfläche (S2) voneinander getrennt sind und die Elektrode (E1) sich so außerhalb des wasserdichten Gehäuses (40) befindet, dass die Elektrode (E1) elektrisch mit der mindestens ersten Oberfläche (S1) und mit der mindestens zweiten Oberfläche (S2) gekoppelt ist, um mindestens zwei Erkennungsbereiche für Annäherung- und/oder Kontakt (Z1, Z2) zu schaffen.

2. Vorrichtung (D) nach dem vorhergehenden Anspruch, **dadurch gekennzeichnet, dass** das wasserdichte Gehäuse (40) einen Reflektor (R1) und Lampen aufweist und dass die erste Metalloberfläche (S1) in Form von Teilen des Reflektors (R1) vorliegt.

3. Vorrichtung (D) nach Anspruch 1 oder 2, **dadurch gekennzeichnet, dass** das wasserdichte Gehäuse einen dekorativen Teil (R2) aufweist und dass die zweite Oberfläche (S2) in Form des dekorativen Teils (R2) vorliegt.

4. Vorrichtung (D) nach dem vorhergehenden Anspruch, **dadurch gekennzeichnet, dass** der dekorative Teil (R2) zumindest teilweise um den Reflektor (R1) herum angeordnet ist.

5. Vorrichtung (D) nach einem der vorhergehenden Ansprüche, **dadurch gekennzeichnet, dass** die Bewegung eine Hin- und Herbewegung vor der Vorrichtung (D) ist und dass die vorbestimmte Anzahl von Peaks vier beträgt.

6. Scheinwerfer (100) eines Kraftfahrzeugs (V), der die Vorrichtung (D) nach einem der vorhergehenden Ansprüche aufweist.

7. Kraftfahrzeug (V), das eine Vorrichtung (D) nach einem der Ansprüche 1 bis 4 aufweist.

8. Verfahren zum Öffnen/Schließen eines Öffnungselements eines Kraftfahrzeugs durch Erkennung der Bewegung eines Gliedmaßes eines Benutzers mithilfe einer Vorrichtung zum Öffnen/Schließen (D), die einen Sensor zur Erkennung von Annäherung und/oder Kontakt (10) aufweist, der eine einzelne Elektrode (E1) und Mittel zur Analyse der Kapazitätsänderungen der Elektrode (E1) aufweist, sowie eine Steuereinheit zum Öffnen/Schließen des Öffnungselements (50), wobei das Verfahren **dadurch gekennzeichnet ist, dass** man die Vorrichtung (D) vorher folgendermaßen ausstattet:
a) mit einem wasserdichten Gehäuse (40), das mindestens eine erste Metalloberfläche (S1) und mindestens eine zweite Metalloberfläche (S2) aufweist,
b) mit Mitteln zur Erkennung einer vorbestimmten Form der genannten Änderungen der Elektrode, die eine Folge einer vorbestimmten Anzahl von Spitzen (P1A, P2A, P1B, P2B) mit vorbestimmten Amplituden (S1A, S2A, S2B, S1B) während einer vorbestimmten Dauer (Δt) aufweisen,
wobei die mindestens erste Oberfläche (S1) und die mindestens zweite Oberfläche (S2) voneinander getrennt sind und die Elektrode (E1) sich so außerhalb des Gehäuses (40) befindet, dass die Elektrode (E1) elektrisch mit der mindestens ersten Oberfläche (S1) und der mindestens zweiten Oberfläche (S2) gekoppelt ist, um mindestens zwei Erkennungsbereiche für Annäherung- und/oder Kontakt (Z1, Z2) zu schaffen,
und dass das Verfahren die folgenden Schritte aufweist:
c) Erkennung einer vorbestimmten Form der genannten Änderungen der Elektrode (E1), die eine Folge einer vorbestimmten Anzahl von Spitzen (P1A, P2A, P1B, P2B) mit vorbestimmten Amplituden (S1A, S2A, S2B, S1B) während einer vorbestimmten Dauer (Δt) aufweisen,
d) Öffnen/Schließen des Öffnungselements entsprechend der so erfolgten Erkennung.

9. Verfahren nach dem vorherigen Anspruch, **dadurch gekennzeichnet, dass** die Bewegung eine Hin- und Herbewegung vor der Vorrichtung (D) ist und dass die vorbestimmte Anzahl von Peaks vier beträgt.

## Claims

1. Device (D) for opening/closing an opening element of a motor vehicle by detecting movement of a user's limb, said device (D) comprising an approach and/or contact detection sensor (10) comprising a single electrode (E1) and analysis means for analysing the variations in capacitance of the electrode (E1), and an opening element opening/closing control unit (50), said device (D) being **characterized in that** it also comprises:
a) a sealed housing (40) comprising at least one first metal surface (S1) and at least one second metal surface (S2),
b) detection means (M1) for detecting a predetermined form of said variations of the electrode (E1), exhibiting a succession of a predetermined number of peaks (P1A, P2A, P1B, P2B) of predetermined amplitudes (S1A, S2A, S2B, S1B) within a predetermined period (Δt),
the at least first surface (S1) and the at least second surface (S2) being separate, and said electrode (E1) being located outside the sealed housing (40), in such a way that said electrode (E1) is coupled electrically to the at least first surface (S1) and to the at least second surface (S2) so as to create at least two approach and/or contact detection areas (Z1, Z2).

2. Device (D) according to the preceding claim, **characterized in that** the sealed housing (40) comprises a reflector (R1) and lamps, and **in that** the first metal surface (S1) takes the form of parts of the reflector (R1) .

3. Device (D) according to Claim 1 or 2, **characterized in that** the sealed housing comprises a decorative part (R2), and **in that** the second surface (S2) takes the form of the decorative part (R2).

4. Device (D) according to the preceding claim, **characterized in that** the decorative part (R2) is located at least partially around the reflector (R1).

5. Device (D) according to any one of the preceding claims, **characterized in that** the movement is a back and forth movement across the device (D), and **in that** the predetermined number of peaks is four.

6. Lamp (100) for a motor vehicle (V) comprising the device (D) according to any one of the preceding claims.

7. Motor vehicle (V) comprising a device (D) according to any one of Claims 1 to 4.

8. Method for opening/closing an opening element of a motor vehicle by detecting movement of a user's limb, using an opening/closing device (D) comprising an approach and/or contact detection sensor (10) comprising a single electrode (E1) and analysis means for analysing the variations in capacitance of the electrode (E1), and an opening element opening/closing control unit (50), said method being **characterized in that** said device (D) is equipped in advance with:
a) a sealed housing (40) comprising at least one first metal surface (S1) and at least one second metal surface (S2),
b) detection means for detecting a predetermined form of said variations of the electrode, exhibiting a succession of a predetermined number of peaks (P1A, P2A, P1B, P2B) of predetermined amplitudes (S1A, S2A, S2B, S1B) within a predetermined period (Δt),
the at least first surface (S1) and the at least second surface (S2) being separate, said electrode (E1) being located outside the housing (40), in such a way that said electrode (E1) is coupled electrically to the at least first surface (S1) and the at least second surface (S2) so as to create at least two approach and/or contact detection areas (Z1, Z2),
and **in that** said method comprises the following steps:
c) detecting a predetermined form of said variations of the electrode (E1), exhibiting a succession of a predetermined number of peaks (P1A, P2A, P1B, P2B) of predetermined amplitudes (S1A, S2A, S2B, S1B) within a predetermined period (Δt),
d) opening/closing the opening element according to the detection thus performed.

9. Method according to the preceding claim, **characterized in that** the movement is a back and forth movement across the device (D), and **in that** the predetermined number of peaks is four.
